**Europäisches Patentamt**

(19) **European Patent Office**

**Office européen des brevets**

(11) Veröffentlichungsnummer: **0 018 572**
**B1**

(12) # EUROPÄISCHE PATENTSCHRIFT

(45) Veröffentlichungstag der Patentschrift:
**20.07.83**

(51) Int. Cl.³: **G 10 H 1/057**

(21) Anmeldenummer: **80102141.1**

(22) Anmeldetag: **21.04.80**

(54) Halbleiterschaltung für die Amplitudenmodulation von Folgen periodischer Wechselspannungssignale.

(30) Priorität: **25.04.79 DE 2916765**

(43) Veröffentlichungstag der Anmeldung:
**12.11.80 Patentblatt 80/23**

(45) Bekanntmachung des Hinweises auf die Patenterteilung:
**20.07.83 Patentblatt 83/29**

(84) Benannte Vertragsstaaten:
**FR GB**

(56) Entgegenhaltungen:
**DE-A-2 535 875**
**US-A-3 819 844**

**ELECTRONICS, Band 48, Nr. 15, 24. Juli 1975, New York, US, J. EDRINGTON: «D-a converter forms programable gain control», Seite 92**

(73) Patentinhaber: **SIEMENS AKTIENGESELLSCHAFT, Berlin und München Wittelsbacherplatz 2, D-8000 München 2 (DE)**

(72) Erfinder: **Rösler, Helmut, Ottobrunner Strasse 101, D-8000 München 83 (DE)**
Erfinder: **Mühlbauer, Otto, Germersheimer Strasse 7, D-8000 München 80 (DE)**
Erfinder: **Bigall, Klaus-Dieter, Dipl.-Phys., Irisstrasse 28, D-8011 Vaterstetten (DE)**

Halbleiterschaltung für die Amplitudenmodulation von Folgen periodischer Wechselspannungssignale

Die Erfindung betrifft eine Halbleiterschaltung für die Amplitudenmodulation von Folgen periodischer Wechselspannungssignale mit einem Signaleingang, einem die Modulation bewirkenden Schaltungsteil, der eine Anzahl von einander gleichen Transistoren mit je zwei stromführenden Anschlüssen und einem Steueranschluss aufweist, einem n Zählstufen aufweisenden und von einem Taktgeber mit Zählimpulsen gesteuerten Digitalzähler, der mit den Steueranschlüssen der Transistoren verbunden ist, und einem Signalausgang, mit dem die Transistoren über ein Widerstandsnetzwerk verbunden sind.

Eine solche Schaltung ist an sich durch die DE-OS 2 535 875 bekannt, die sich auf ein tonformendes Dämpfungsregler-Netzwerk zur Verwendung bei einem Musikinstrument bezieht, welches die Aufgabe hat, die Dämpfung von Tonsignalen gemäss vorher festgelegter Muster zu bewirken.

Dabei handelt es sich beim Betrieb von elektronischen Musikgeräten (aber auch bei Geräten zur Sprachsynthesierung) um das Problem, elektrische Wechselstromsignale, die sich aus periodischen Schwingungen, z.B. aus Sinusschwingungen, aus Rechteckschwingungen, aus Sägezahnschwingungen, zusammensetzen können, so umzuformen, dass die Amplitude der einzelnen Schwingungen beginnend von einem sehr kleinen Wert sich allmählich zu immer grösseren Werten bis zu einem Maximum steigert, um dann – ggf. nach einem Verbleib auf dem Höchstwert – wieder monoton bis zu einem verschwindend kleinen Wert abzufallen. Ausserdem ist dabei wichtig, dass die Amplitudenänderung nicht auf das Bezugspotential (Masse), sondern auf ein höheres Potential VM bezogen wird, das z.B. in der Mitte zwischen dem Bezugspotential und dem anderen Versorgungspotential liegt. Eine solche Modulation wäre z.B. beim Einschalten des Tons bei elektrischen Musikgeräten angebracht, weil sie, wie die Untersuchung mit einer Fourieranalyse zeigt, frei von dem sonst beim Einsetzen bzw. Abfallen der Schwingungen auftretenden Gleichspannungssprung ist, so dass der unangenehme Knackton auf diese Weise vermieden werden kann.

Die Aufgabe der Erfindung besteht darin, eine monolithisch integrierbare Halbleiterschaltung anzugeben, welche zur Abgabe der im vorstehend angegebenen Sinne geformten Wechselspannungs- bzw. Wechselspannungsimpulsfolgen geeignet ist. Wesentlich ist dabei ausserdem, dass der technische Aufwand im Vergleich zu den Schaltungen nach der DE-OS 2 535 875 merklich reduziert ist.

Hierzu wird eine der eingangs gegebenen Definition entsprechende Halbleiterschaltung derart ausgebildet, dass der Signaleingang direkt an den einen stromführenden Anschluss der n ersten Transistoren gelegt und jeder dieser n Transistoren mit einem zweiten solchen Transistor zu je einem Transistorpaar zusammengefasst ist, indem der andere stromführende Anschluss des ersten Transistors jedes Transistorpaars mit dem entsprechenden einen stromführenden Anschluss des zugehörigen zweiten Transistors verbunden und ausserdem über je eine von n verschiedenen Widerstandskombinationen an den Signalausgang der Schaltung gelegt ist, dass ferner die den einzelnen Transistorpaaren jeweils zugeordneten Widerstandskombinationen zusammen ein Widerstands-Netzwerk bilden und dass die anderen stromführenden Anschlüsse der zweiten Transistoren aller dieser Transistorpaare an einem gemeinsamen und vom Bezugspotential (Masse) verschiedenen Betriebspotential liegen und dass schliesslich beide Steueranschlüsse jedes dieser Transistorpaare jeweils mit den Ausgängen einer Zählstufe des Digitalzählers verbunden sind.

Abgesehen vom Digitalzähler kommt eine solche Schaltung, wie aus der die Erfindung darstellenden Zeichnung hervorgeht, mit einem Minimum an technischem Aufwand aus, da ausser den in der soeben gebrachten Definition der Erfindung genannten Schaltungsteilen keine weiteren Schaltungsmittel zur Lösung der genannten Aufgabe erforderlich sind. Damit ist aber ein wesentlicher Vorteil der Erfindung gegenüber den in der DE-OS 2 535 875 angegebenen Möglichkeiten gewährleistet.

Die Einzeltransistoren der Transistorpaare sind entweder Bipolartransistoren oder Feldeffekttransistoren vom MIS-Typ, insbesondere vom MOS-Typ. Im ersten Fall sind die Steuerelektroden durch die Basisanschlüsse der einzelnen Transistoren und die beiden stromführenden Anschlüsse durch den Emitter und den Kollektor gegeben. In diesem Fall sind die Kollektoren der beiden Transistoren der einzelnen Transistorpaare mit einander verbunden und über das Widerstandsnetzwerk an den Signalausgang der Schaltung gelegt, während der Emitter des jeweils ersten Transistors mit den umzuformenden Signalfolgen und der Emitter des jeweils zweiten Transistors mit einem vom Bezugspotential (Masse) verschiedenen konstanten Betriebspotential VM zu beaufschlagen ist, welches zwischen dem an Masse liegenden Bezugspotential und dem höchsten zum Betrieb des Digitalzählers verwendeten Betriebspotential, insbesondere in der Mitte zwischen den beiden Potentialen, liegt. Zu bemerken ist dabei noch, dass in diesem Fall sich auch die die Zählstufen des Digitalzählers bildenden Flip-Flopzellen aus logischen Gattern (NOR- oder NAND-Gattern) zusammensetzen, die Bipolartransistoren und ggf. auch aus Dioden als Hauptbestandteil aufweisen.

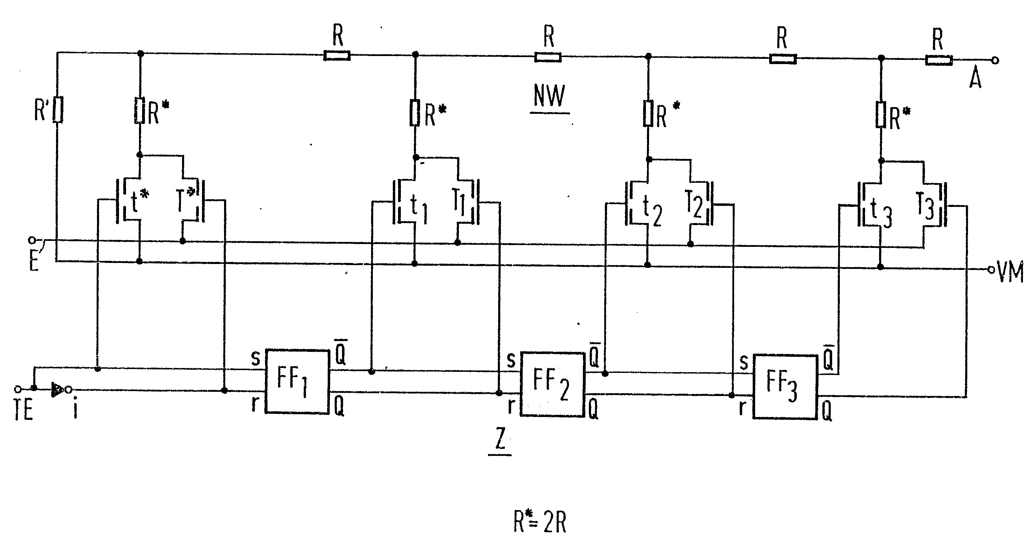

In dem in der Figur dargestellten Fall sind die Transistoren einander gleiche MIS-Feldeffekttransistoren, insbesondere vom Anreicherungstyp. Unter Bezugnahme auf die Figur ist dabei folgendes festzustellen.

Der Index «i» läuft von 1 bis n, wobei n die Gesamtzahl der Zählstufen des Digitalzählers Z ist und die Zählung mit der unmittelbar mit den Zählimpulsen beaufschlagten ersten Zählstufe $FF_1$ beginnt und in der Reihenfolge der Zählstufen $FF_i$ in der den Zähler bildenden Kette von Zählstufen fortschreitet. Das zur i-ten Zählstufe $FF_i$ gehörende Transistorpaar besteht aus den beiden einander gleichen MIS-Feldeffekttransistoren $T_i$ und $t_i$, wobei − entsprechend der gewählten Bezeichnungsweise − der Transistor $T_i$ als der erste Transistor und der Transistor $t_i$ als der zweite Transistor gilt. Entsprechend der Erfindung werden die beiden Transistoren $T_i$ und $t_i$ jeweils zu dem betreffenden Transistorpaar zusammengefasst, indem ihre Drainanschlüsse miteinander verbunden und über eine dem betreffenden Transistorpaar zugeordnete Kombination $R_i$ von Widerständen an den Signalausgang A der Schaltung gelegt sind.

Entsprechend der Erfindung ist ferner der Sourceanschluss des ersten Transistors $T_i$ des i-ten Transistorpaares mit dem durch die zu formenden Impulsfolgen zu beaufschlagenden Signaleingang E der Schaltung und der Sourceanschluss des zweiten Transistors $t_i$ mit einem vom Bezugspotential verschiedenen und zwischen diesem und dem grössten für den Betrieb des Digitalzählers Z erforderlichen Betriebspotential liegenden mittleren Betriebspotential VM beaufschlagten Versorgungseingang verbunden.

Bei dem in der Zeichnung dargestellten Ausführungsbeispiel ist der Digitalzähler Z ein Dualzähler, so dass die einzelnen Zählstufen $FF_i$ aus je einer Flip-Flopzelle, insbesondere einer Toggle-Flip-Flopzelle, bestehen. Demzufolge hat jede Zählstufe $FF_i$ zwei Signaleingänge und zwei Signalausgänge, welch letztere mit Q bzw. $\bar{Q}$ bezeichnet sind. Die jeweiligen Zählerstände werden durch die Gesamtheit der Ausgänge Q und $\bar{Q}$ unter Beachtung der Reihenfolge i der Flip-Flopzellen geliefert, wobei $\bar{Q}$ den invertierten Zählerstand und Q den der bisher eingegebenen Anzahl von Zählimpulsen entsprechenden Zählstand wiedergeben. Die Zählimpulse werden über den Zähleingang TE des Dualzählers Z unmittelbar an den einen Eingang und über einen Inverter I an den anderen Informationseingang der ersten Flip-Flopzelle $FF_1$ der Zählerkette Z gegeben. Die beiden Ausgänge Q und $\bar{Q}$ der ersten Flip-Flopzelle $FF_1$ liegen an je einem der beiden Informationseingänge der zweiten Flip-Flopzelle $FF_2$. Allgemein sind die beiden Ausgänge der i-ten Flip-Flopzelle $FF_i$ mit je einem der beiden Informationseingänge der folgenden Flip-Flopzelle $FF_{i+1}$ verbunden.

Bei Anwendung eines derart aufgebauten Zählers Z ist es zweckmässig, zusätzlich noch ein weiteres Transistorpaar $T^*$, $t^*$ vorzusehen, das in entsprechender Weise wie die übrigen Transistorpaare $T_i$, $t_i$ durch den Signaleingang E und das Potential VM beaufschlagt und mit dem Ausgang A der Schaltung verbunden ist, während zu seiner Steuerung unmittelbar der Eingang TE für die Zählimpulse bzw. der Inverter I vorgesehen sind. Demzufolge ist der erste Transistor $T^*$ dieses Transistorpaares mit seinem Trainanschluss und dem Drainanschluss des ihm gleichen zweiten Transistors $t^*$ über eine weitere Widerstandskombination an den Ausgang A der Schaltung gelegt, während der Sourceanschluss des ersten Transistors $T^*$ am Signaleingang E der Schaltung und der Sourceanschluss des zweiten Transistors $t^*$ an dem mittleren Betriebspotential VM liegen. Das Gate des ersten Transistors $T^*$ wird durch den Ausgang des Inverters I und das Gate des zweiten Transistors $t^*$ unmittelbar durch den Zähleingang TE des Dualzählers Z gesteuert.

Der Grundbestandteil des Widerstands-Netzwerkes NW ist eine aus n einander gleichen Widerständen R bestehende Widerstandskette, die am einen Ende durch den Signalausgang A der Schaltung abgeschlossen und an ihrem anderen Ende über einen Überbrückungswiderstand R' an das zur Beaufschlagung der Sourceanschlüsse der zweiten Transistoren $t_i$ der Transistorpaare $T_i$, $t_i$ vorgesehene mittlere Betriebspotential VM gelegt ist. Zwischen je zwei benachbarten Einzelwiderständen R der Widerstandskette sowie zwischen dem Überbrückungswiderstand R' und dem ihm benachbarten Einzelwiderstand R der Widerstandskette ist je ein Schaltungsknoten vorgesehen, von dem aus über je einen Ergänzungswiderstand $R^*$ eine leitende Verbindung zu den beiden Transistoren $T_i$, $t_i$ des i-ten Transistorpaares hergestellt ist. Die Anschaltung ist dabei derart getroffen, dass zwischen den Drainanschlüssen der beiden Transistoren $T_i$, $t_i$ des durch die i-te Zählstufe $FF_i$ des Dualzählers Z Transistorpaares und dem Ausgang A der Schaltung jeweils die Serienschaltung aus einem Ergänzungswiderstand $R^*$ und $(n + 1−i)$ Einzelwiderstände R gelegt ist.

Zu erwähnen ist, dass die einander gleich bemessenen Ergänzungswiderstände $R^*$ auf den doppelten Wert der Einzelwiderstände R der Widerstandskette eingestellt sind und somit $R^* = 2R$ gilt. Der Überbrückungswiderstand R' ist zweckmässig so eingestellt, dass $R' = R^*$.

Falls zu den normalerweise benötigten n Transistorpaaren noch ein weiteres Transistorpaar $T^*$, $t^*$ vorgesehen und in der oben beschriebenen Weise an den Zähleingang TE des Dualzählers Z, an das mittlere Betriebspotential VM und an den Signaleingang E angeschaltet ist, dann ist − wie aus der Zeichnung ersichtlich − die Kette aus einander gleichen Widerständen R um einen weiteren Widerstand R zu verlängern. Dann liegen die kombinierten Drainanschlüsse der beiden Transistoren des ersten Transistorpaars $T_1$, $t_1$ nicht mehr am Ende der aus den Widerständen R gebildeten Kette, sondern zwischen den − vom Signalausgang A her gesehen − beiden letzten dieser Widerstände R an der Widerstandskette an. Die Drains der beiden Transistoren $T^*$ und $t^*$ des zusätzlichen Transistorpaares sind dann − wiederum über einen Ergänzungswiderstand $R^*$ − an dem zwischen dem letzten Widerstand R der Kette und dem Überbrückungswiderstand R' liegenden Schaltungsknoten angeschlossen.

Die auf den Eingang E zu gebenden Impulsfolgen bestehen aus einander gleichen Impulsen, z.B. aus sinusförmigen Impulsen oder aus Rechteckimpulsen oder aus Sägezahnimpulsen. Ihre Frequenz ist auf einen höheren Wert als die Frequenz der – zweckmässig ebenfalls periodisch anfallenden – Zählimpulse für den Eingang TE des Digitalzählers Z eingestellt.

Hinsichtlich der beschriebenen Schaltung ist nun folgendes festzustellen: Durch das Zusammenwirken des Dualzählers Z und der beiden Transistoren $T_i$ und $t_i$ der einzelnen Transistorpaare wird die über den Eingang E zugeführte Impulsfolge konstanter Amplituden in eine nicht mehr auf das Bezugspotential, also Masse, bezogene Impulsfolge, d.h. in eine auf das mittlere Betriebspotential VM bezogene Impulsfolge umgewandelt, die am Ausgang A der Schaltung abgenommen werden kann. Ist der Zähler in der Ausgangsstellung und somit sein Zählstand identisch Null, so ist wegen des hohen Wertes des Widerstands der dann massgebenden Widerstandskombination $R_i$ die Amplitude des am Ausgang A erscheinenden Signals sehr klein. Mit fortschreitendem Zählerstand wächst die Amplitude der am Ausgang A erscheinenden Signale und erreicht mit dem Maximum des Zählstandes auch ihren maximalen Wert. Es wird somit eine Impulsfolge am Ausgang A erhalten, deren Hüllkurve sich zunehmend erweitert.

Wird der Dualzähler Z in bekannter Weise als Vorwärts-Rückwärtszähler ausgebildet, so kann man nach dem Erreichen des höchsten Zählstandes diesen und damit die Amplituden der Einzelimpulse sukzessive wieder abbauen.

Statt eines Dualzählers kann auch z.B. ein Dezimalzähler oder ein Hexadezimalzähler als Digitalzähler Z im Prinzip verwendet werden. Jedoch ist dann der Aufwand an Transistoren bedingt durch den komplizierteren Aufbau der Zählstufen entsprechend grösser.

Ferner ist für die Beaufschlagung des Dualzählers Z mit Zählimpulsen ein Oszillator mit konstanter Frequenz vorgesehen. Bevorzugt liefert dieser Sinusschwingungen, deren Hüllkurve dann mit Hilfe der vorgeschlagenen Halbleiterschaltung umgeformt werden kann. Ersichtlich ist die Wirkung auch dann gegeben, wenn die Gestalt der Einzelimpulse der zu formenden Impulsfolgen nicht sinusförmig, sondern z.B. rechteckförmig oder trapezförmig oder sägezahnförmig ist. Schliesslich ist eine strenge Periodizität der umzuformenden Signale keine für die Wirksamkeit der Schaltung unbedingt erforderliche Voraussetzung.

In der DE-Patentanmeldung P 2 833 211.8 (VPA 78 P 1130) ist ein elektronischer Zähler für elektrische Digitalimpulse beschrieben, dessen Zählstufen je einen Q-Ausgang und einen Q̄-Ausgang aufweisen und der sowohl auf den Betrieb als Vorwärtszähler als auch auf den Betrieb als Rückwärtszähler umschaltbar ist, und der sich durch einen besonders einfachen Aufbau der die Umschaltung bewirkenden Schaltungsteile auszeichnet. Der in dieser Patentanmeldung P 2 833 211.8 beschriebene Vorwärts-Rückwärtszähler eignet sich in besonderem Masse für den Dualzähler Z gemäss der vorliegenden Erfindung.

Dies gilt vor allem dann, wenn die Erfindung für die Tonerzeugung eines elektronischen Musikgerätes, insbesondere einer elektronischen Orgel, eingesetzt wird. Dort wird durch den Druck auf eine Spieltaste ein entsprechend der gewünschten Tonfrequenz schwingender Oszillator aktiviert oder die betreffende Tonfrequenz über einen Frequenzteiler erzeugt. Das jeweils angeschlagene und durch eine entsprechende Schwingungsfolge gegebene elektrische Tonsignal wird dann unmittelbar mit seinem Auftreten an den Signaleingang E der gemäss der Erfindung vorgeschlagenen Halbleiterschaltung gelegt und mit allmählich ansteigenden Amplituden versehen. Ist der maximale Zählstand erreicht, dann wird die weitere Zufuhr von Zählimpulsen so lange unterbunden, bis die Spieltaste wieder losgelassen wird. In diesem Augenblick setzt erneut die Zufuhr von Zählimpulsen ein, wodurch der nunmehr auf den Betrieb als Rückwärtszähler geschaltete Dualzähler die Amplitude des durch entsprechende Massnahmen weiter aufrechterhaltenen elektrischen Tonsignals bis zum Verschwinden abgebaut wird. Der die betreffende Tonfrequenz liefernde Oszillator wird dann abgeschaltet, um erst bei erneuter Betätigung der betreffenden Spieltaste wieder aktiviert zu werden.

Wie bereits soeben angedeutet wurde, können dabei entsprechend den Tönen der höchsten Oktave schwingende Oszillatoren vorgesehen sein, die dann über Frequenzteilerstufen, die den Tönen der niedrigeren Oktaven entsprechende elektrische Schwingungen erzeugen. Ferner können die für die Beaufschlagung des Dualzählers Z dienenden Zählimpulse von einem Oszillator mit konstanter Frequenz über umschaltbare Frequenzteilerstufen an den Eingang TE des Dualzählers Z geliefert werden. Hierdurch lassen sich auch nichtlineare Hüllkurven für die Amplituden der am Ausgang A erscheinenden Signale realisieren.

**Patentansprüche**

1. Halbleiterschaltung für die Amplitudenmodulation von Folgen periodischer Wechselspannungssignale mit einem Signaleingang, einem die Modulation bewirkenden Schaltungsteil, der eine Anzahl von n einander gleichen Transistoren mit je zwei stromführenden Anschlüssen und einem Steueranschluss aufweist, einem n Zählstufen aufweisenden und von einem Taktgeber mit Zählimpulsen gesteuerten Digitalzähler, der mit den Steueranschlüssen der Transistoren verbunden ist, und einem Signalausgang, mit dem die Transistoren über ein Widerstandsnetzwerk verbunden sind, dadurch gekennzeichnet, dass der Signaleingang (E) direkt an den einen stromführenden Anschluss der n ersten Transistoren ($T_i$) gelegt und jeder dieser n Transistoren ($T_i$) mit einem zweiten solchen Transistor ($t_i$) zu je einem Transistorpaar zusammengefasst ist, indem der andere stromführende Anschluss des ersten Transistors ($T_i$) jedes Transistorpaares mit dem entsprechenden einen stromführenden Anschluss des zugehörigen zweiten Transistors ($t_i$) verbunden und ausserdem über je eine von n verschiedenen Widerstandskombinationen ($R_i$) an den Signalausgang (A) der Schaltung gelegt ist, dass ferner die den einzelnen Transistorpaaren ($T_i$, $t_i$) jeweils zugeordneten Widerstandskombinationen ($R_i$) zusammen ein Widerstands-Netzwerk (NW) bilden und dass die anderen stromführenden Anschlüsse der zweiten Transistoren ($t_i$) aller dieser Transistorpaare an einem gemeinsamen und vom Bezugspotential (Masse) verschiedenen Betriebspotential (VM) liegen und dass schliesslich beide Steueranschlüsse jedes dieser Transistorpaare jeweils mit den Ausgängen (Q, $\bar{Q}$) einer Zählstufe ($FF_i$) des Digitalzählers (Z) verbunden sind.

2. Halbleiterschaltung nach Anspruch 1, dadurch gekennzeichnet, dass die Transistorpaare ($T_i$, $t_i$) aus Bipolartransistoren vom gleichen Typ bestehen, dass dabei die Basiselektroden der einzelnen Transistoren der Transistorpaare jeweils an je einen Ausgang (Q, $\bar{Q}$) je einer Zählstufe ($FF_i$) des Digitalzählers (Z) angeschlossen und die Kollektoren dieser Transistoren ($T_i$ $t_i$) gemeinsam über die jeweils zugehörige Widerstandskombination ($R_i$) an den Ausgang (A) der Schaltung angeschlossen sind.

3. Halbleiterschaltung nach Anspruch 1, dadurch gekennzeichnet, dass die Transistorpaare aus einander gleichen MIS-Feldeffekttransistoren, insbesondere MOS-Feldeffekttransistoren, bestehen und dass die Gateanschlüsse dieser Feldeffekttransistoren (T, $t_i$) von den Ausgängen (Q, $\bar{Q}$) der Zählstufen ($FF_i$) des Digitalzählers (Z) gesteuert sind.

4. Halbleiterschaltung nach einem der Ansprüche 1 bis 3, dadurch gekennzeichnet, dass der Digitalzähler (Z) ein Dualzähler ist, dessen einzelne Zählstufen ($FF_i$) durch je eine Flip-Flopzelle, z.B. je eine Toggle-Flip-Flopzelle, gegeben sind.

5. Halbleiterschaltung nach Anspruch 4, dadurch gekennzeichnet, dass – gerechnet vom Zähleingang (TE) – die i-te Zählstufe ($FF_i$) mit ihrem einen Ausgang ($\bar{Q}$) mit der Steuerelektrode des zugleich durch den Signaleingang (E) beaufschlagten ersten Transistors ($T_i$) des jeweils zugehörnden Transistorpaares ($T_i$, $t_i$) verbunden ist, während der andere Ausgang (Q) der betreffenden Zählstufe ($FF_i$) an der Steuerelektrode des zweiten Transistors ($t_i$) des jeweils zugehörigen Transistorpaares (T, $t_i$) liegt.

6. Halbleiterschaltung nach Anspruch 4 oder 5, dadurch gekennzeichnet, dass der Dualzähler (Z) derart geschaltet ist, dass die beiden Signaleingänge der jeweils nachfolgenden Zählstufe ($FF_{i\pm1}$) mit je einem der beiden Signalausgänge (Q, $\bar{Q}$) der jeweils vorgeschalteten Zählstufe ($FF_i$) verbunden sind und dass die von einem Taktgeber gelieferten Zählimpulse unmittelbar an den einen Eingang der ersten Zählstufe ($FF_1$) und über einen Inverter (I) an den anderen Eingang dieser Zählstufe gelangen.

7. Halbleiterschaltung nach einem der Ansprüche 4 bis 6, dadurch gekennzeichnet, dass die durch den Signaleingang (E) gesteuerten ersten Transistoren ($T_i$) der einzelnen Transistorpaare ($T_i$, $t_i$) an denjenigen Ausgang ($\bar{Q}$) der jeweils zugeordneten Zählstufe ($FF_i$) liegen, der unmittelbar vor dem Starten des Dualzählers (Z) den Zustand EINS hat.

8. Halbleiterschaltung nach einem der Ansprüche 4 bis 7, dadurch gekennzeichnet, dass das der i-ten Zählstufe ($FF_i$) zugeteilte Transistorpaar ($T_i$, $t_i$) mittels einer aus (n+1–i) hintereinandergeschalteten gleichen Einzelwiderständen (R) und einem lediglich dem betreffenden Transistorpaar ($T_i$, $t_i$) zugeteilten Ergänzungstransistor ($T^*$) bestehenden Widerstandskette an den Ausgang (A) der Halbleiterschaltung gelegt ist und dass dabei die auf den Ausgang (A) führenden letzten (n–i) dieser Widerstände (R) dem der folgenden Zählstufe ($FF_{i+1}$) zugeteilten Transistorpaar ($T_{i+1}$, $t_{i+1}$) ebenfalls jeweils zugeteilt sind.

9. Halbleiterschaltung nach Anspruch 8, dadurch gekennzeichnet, dass das zur Beaufschlagung der zweiten Transistoren ($t_i$) der Transistorpaare ($T_i$, $t_i$) dienende Versorgungspotential (VM) über einen Überbrückungswiderstand (R') mit dem vom Ausgang (A) abgewandten Ende der aus (n+1) bzw. (n+2) einander gleichen Einzelwiderständen (R) bestehenden Widerstandskette verbunden und über diese an den Ausgang (A) der Halbleiterschaltung gelegt ist.

10. Halbleiterschaltung nach Anspruch 8 oder 9, dadurch gekennzeichnet, dass sowohl die Ergänzungswiderstände ($R^*$) als auch der Überbrückungswiderstand (R') den doppelten Widerstandswert der die Widerstandskette bildenden Einzelwiderstände (R) aufweisen.

11. Halbleiterschaltung nach einem der Ansprüche 6 bis 10, dadurch gekennzeichnet, dass der die Zähltakte führende Eingang (TE) des Dualzählers (Z) und der Ausgang des die erste Zählstufe ($FF_i$) beaufschlagenden Inverters (I) zur Steuerung eines weiteren Transistorpaares ($T^*$, $t^*$) dienen, dass die beiden miteinander verbundenen Anschlüsse der Transistoren dieses Transistorpaares über die (n+2) hintereinandergeschaltete Einzelwiderstände (R) aufweisende Widerstandskette und einem diesem zusätzlichen Transistorpaar ($T^*$, $t^*$) ausschliesslich vorbehaltenen Ergänzungswiderstand ($R^*$) mit dem Ausgang (A) der Halbleiterschaltung verbunden sind, während die zweite stromführende Elektrode des durch den Inverter (I) beaufschlagten ersten Transistors ($T^*$) mit dem Signaleingang (E) der Schaltung und die zweite stromführende Elektrode des anderen Transistors ($t^*$) unmittelbar mit dem Betriebspotential (VM) verbunden ist.

12. Halbleiterschaltung nach einem der Ansprüche 1 bis 10, dadurch gekennzeichnet, dass der Zähleingang (TE) von einem zur Abgabe periodischer Zählimpulse befähigten Oszillator als Taktgeber gesteuert ist.

13. Halbleiterschaltung nach einem der Ansprüche 1 bis 11, dadurch gekennzeichnet, dass die Frequenz der Zählimpulse kleiner als die Frequenz der Impulse der an den Signaleingang (E) der Halbleiterschaltung zu legenden Signalfolgen gewählt ist.

14. Halbleiterschaltung nach einem der Ansprüche 1 bis 12, dadurch gekennzeichnet, dass der Digitalzähler als Vorwärts-Rückwärtszähler, insbesondere nach Patentanmeldung P 2 833 211.8, ausgebildet ist.

15. Halbleiterschaltung nach einem der Ansprüche 1 bis 13, dadurch gekennzeichnet, dass sie in monolithischer MIS-Halbleitertechnik bzw. Bipolartechnik zu einem Halbleiterbaustein zusammengefasst ist.

## Claims

1. A semiconductor circuit for the amplitude modulation of sequences of periodic alternating voltage signals, comprising a signal input, a circuit component which effects the modulation and which possesses a number n of mutually identical transistors each having two current path terminals and one control terminal, a digital counter which possesses n counting stages, controlled by counting pulses from a pulse generator and connected to the control terminals of the transistors, and a signal output tp which the transistors are connected via a resistance network, characterised in that the signal input (E) is directly connected to one of the current conducting terminals of the n first transistors $(T_i)$ and each of these n transistors $(T_i)$ is combined with a second such transistor $(t_i)$ to form a pair of transistors, in that the other current conducting terminal of the first transistor $(T_i)$ of each transistor pair is connected to the corresponding first current conducting terminal of the associated second transistor $(t_i)$ and in addition is connected via one of n different resistor combinations $(R_i)$ to the signal output (A) of the circuit, in that the resistor combinations $(R_i)$ each assigned to the individual transistor pairs $(T_i, t_i)$ together form a resistor network (NW), and in that the other current conducting terminals of the second transistors $(t_i)$ of all these transistor pairs are connected to a common operating potential (VM) which differs from the reference potential (earth), and finally in that both the control terminals of each of these transistor pairs are each connected to the outputs $(Q, \bar{Q})$ of a counting stage $(FF_i)$ of the digital counter (Z).

2. A semiconductor circuit as claimed in Claim 1, characterised in that the transistor pairs $(T_i, t_i)$ consist of bipolar transistors of the same type, the base electrodes of the individual transistors of the transistor pairs are each connected to one output $(Q, \bar{Q})$ of a counting stage $(FF_i)$ of the digital counter (Z) and the collectors of these transistors $(T_i, t_i)$ are commonly connected via the associated resistor combination $(R_i)$ to the output (A) of the circuit.

3. A semiconductor circuit as claimed in Claim 1, characterised in that the transistor pairs consist of mutually identical MIS field effect transistors, in particular MOS field effect transistors, and the gate terminals of these field effect transistors $(T_i,$

$t_i)$ are controlled by the outputs $(Q, \bar{Q})$ of the counting stages $(FF_i)$ of the digital counter (Z).

4. A semiconductor circuit as claimed in one of the Claims 1 to 3, characterised in that the digital counter (Z) consists of a dual counter whose individual counting stages $(FF_i)$ are each formed by a flip-flop cell, e.g. a toggle flip-flop cell.

5. A semiconductor circuit as claimed in Claim 4, characterised in that – calculated from the counting input (TE) – the i-th counting stage $(FF_i)$ is connected by its first output $(\bar{Q})$ to the control electrode of the first transistor $(T_i)$, which is simultaneously connected to the signal input (E) of the associated transistor pair $(T_i, t_i)$, whereas the other output (Q) of the relevant counting stage $(FF_i)$ is connected to the control electrode of the second transistor $(t_i)$ of the associated transistor pair $(T_i, t_i)$.

6. A semiconductor circuit as claimed in Claim 4 or 5, characterised in that the dual counter (Z) is connected in such manner that the two signal inputs of the following counting stage $(FF_{i+1})$ are each connected to one of the two signal outputs $(Q, \bar{Q})$ of the particular preceding counting stage $(FF_i)$, and that the counting pulses supplied by a pulse generator are directly fed to the first input of the first counting stage $(FF_1)$ and via an inverter (I) to the other input this counting stage.

7. A semiconductor as claimed in one of the Claims 4 to 6, characterised in that the first transistors $(T_i)$ of the individual transistor pairs $(T_i, t_i)$, controlled by the signal input (E), are connected to that output $(\bar{Q})$ of the assigned counting stage $(FF_1)$ which is in the «ONE» state directly prior to the start of the dual counter (Z).

8. A semiconductor circuit as claimed in one of the Claims 4 to 7, characterised in that the transistor pair $(T_i, t_i)$ assigned to the i-th counting stage $(FF_i)$ is connected to the output (A) of the semiconductor circuit by a resistor chain composed of $(n+1-i)$ series-connected identical individual resistors (R) and a supplementary transistor $(T^*)$ assigned only to the transistor pair $(T_i, t_i)$ in question, and that the last $(n-i)$ of these resistors (R) which lead to the output (A) are likewise each assigned to the transistor pair $(T_{i+1}, t_{i+1})$ allocated to the following counting stage $(FF_{i+1})$.

9. A semiconductor circuit as claimed in Claim 8, characterised in that the supply potential (VM) which serves to feed the second transistors $(t_i)$ of the transistors pairs $(T_i, t_i)$ is connected via a bridging resistor (R') to the end of the resistor chain composed of $(n+1)$ of $(n+2)$ identical individual resistors (R) that is remote from the output (A), and is connected to the output (A) of the semiconductor circuit via said resistor chain.

10. A semiconductor circuit as claimed in Claim 8 or 9, characterised in that both the supplementary resistors $(R^*)$ and the bridging resistor (R') possess double the resistance value of the individual resistors (R) which form the resistor chain.

11. A semiconductor circuit as claimed in one of the Claims 6 to 10, characterised in that the input (TE) of the dual counter (Z) which conducts the counting pulses and the output of the inverter (I) which supplies the first counting stage ($FF_1$) serve to control a further transistor pair (T*, t*), the two terminals of the transistors of this transistor pair which are connected to one another, are connected to the output (A) of the semiconductor circuit via the resistor chain comprising (n+2) series-connected individual resistors (R) and via a supplementary resistor (R*) exclusively reserved for this additional transistor pair (T*, t*), whereas the second current conducting electrode of the first transistor (T*) which is supplied by the inverter (I) is connected to the signal input (E) of the circuit and the second current conducting electrode of the other transistor (t*) is directly connected to the operating potential (VM).

12. A semiconductor circuit as claimed in one of the Claims 1 to 10, characterised in that the counting input (TE) is controlled by a pulse generator in the form of an oscillator capable of emitting periodic counting pulses.

13. A semiconductor circuit as claimed in one of the Claims 1 to 11, characterised in that the frequency of the counting pulses is selected to be lower than the frequency of the pulses of the signal sequences to be connected to the signal input (E) of the semiconductor circuit.

14. A semiconductor circuit as claimed in one of the Claims 1 to 12, characterised in that the digital counter is designed as a forwards/backwards counter, in particular in accordance with Patent Application P 2 833 211.8.

15. A semi-conductor circuit as claimed in one of the Claims 1 to 13, characterised in that it is assembled using monolithic MIS semiconductor technology or bipolar technology to form a semiconductor module.

**Revendications**

1. Circuit à semi-conducteurspour la modulation d'amplitude de trains de signaux ou de tension alternatifs périodiques, qui comporte une entrée de signaux, une partie du circuit, réalisant la modulation, qui comprend un certain nombre de transistors identiques entre eux et possédant respectivement deux bornes sous tension et une borne de commande, un compteur numérique, qui comprend n étages de comptage, commandé par des impulsions de comptage provenant d'un générateur de cadence, et relié aux bornes de commande des transistors, et une sortie de signaux à laquelle les transistors sont reliés par l'intermédiaire d'un réseau de résistances, caractérisé par le fait que l'entrée de signaux (E) est appliqué directement à une des bornes sous tension des n premiers transistors ($T_i$) et que chacun de ces n transistors ($T_i$) est réuni avec un second tel transistor ($T_i$) pour former respectivement une paire de transistors, en reliant l'autre borne sous tension du premier transistor ($t_i$) de chaque paire de transistors à une des bornes sous tension correspondantes du second transistor associé ($t_i$), et en l'appliquant en outre, respectivement par l'intermédiaire d'une des n combinaisons de résistances différentes ($R_i$), à la sortie de signaux (A) du circuit, qu'en outre les combinaisons de résistances ($R_i$) respectivement associées aux paires de transistors individuelles ($T_i$, $t_i$) forment conjointement un réseau de résistances (NW), et que les autres bornes sous tension des seconds transistors ($t_i$) de toutes ces paires de transistors se trouvent à un potentiel de service (VM) commun qui diffère du potentiel de référence (masse), et qu'enfin les deux bornes de commande de chacune de ces paires de transistors sont respectivement reliées aux sorties (Q, $\bar{Q}$) d'un étage de comptage ($FF_i$) du compteur numérique (Z).

2. Circuit à semi-conducteurs suivant la revendication 1, caractérisé par le fait que les paires de transistors ($T_i$, $t_i$) sont constituées par des transistors bipolaires du même type, que ce faisant, les électrodes de base des transistors individuels des paires de transistors sont respectivement reliées à une sortie respective (Q, $\bar{Q}$) d'un étage de comptage respectif ($FF_i$) du compteur numérique (Z), et les collecteurs de ces transistors ($T_i$, $t_i$) sont reliés en commun, par l'intermédiaire de la combinaison de résistance ($R_i$) respectivement associée, à la sortie (A) du circuit.

3. Circuit à semi-conducteurs suivant la revendication 1, caractérisé par le fait que les paires de transistors sont constituées par des transistors à effet de champ MIS identiques entre eux, notamment des transistors à effet de champ MOS, et que les bornes de porte de ces transistors à effet de champ ($T_i$, $t_i$) sont commandées par les sorties (Q, $\bar{Q}$) des étages de comptage ($FF_i$) du compteur numérique (Z).

4. Circuit à semi-conducteurs suivant une des revendications 1 à 3, caractérisé par le fait que le compteur numérique (Z) est un compteur dual dont les étages de comptage respectifs ($FF_i$) sont formés respectivement par un circuit de bascule, par exemple respectivement un circuit de bascule dit flip-flop.

5. Circuit à semi-conducteurs suivant la revendication 4, caractérisé par le fait que – à partir de l'entrée de comptage (TE) – une des sorties ($\bar{Q}$) du $i^{ième}$ étage de comptage ($FF_i$) est reliée à l'électrode de commande du premier transistor ($T_i$), alimentée simultanément par l'entrée de signaux (E), de la paire de transistors respectivement associée ($T_i$, $t_i$), tandis que l'autre sortie (Q) de l'étage de comptage concerné ($FF_i$) est reliée à l'électrode de commande du second transistor ($t_i$) de la paire de transistors respectivement associée ($T_i$, $t_i$).

6. Circuit à semi-conducteurs suivant la revendication 4 ou 5, caractérisé par le fait que le compteur dual (Z) est branché de manière que les deux entrées de signaux de l'étage de comptage respectivement suivant ($FF_{i+1}$) soient respectivement reliées à une des deux sorties de signaux (Q, $\bar{Q}$) de l'étage de comptage précédent respectif ($FF_i$), et que les impulsions de comptage délivrées par un générateur de cadence arrivent directement sur une des entrées du premier étage de comptage ($FF_1$) et par l'intermédiaire d'un inverseur (I) sur l'autre entrée de cet étage de comptage.

7. Circuit à semi-conducteurs suivant l'une des revendications 4 à 6, caractérisé par le fait que les premiers transistors ($T_i$), commandés par l'entrée de signaux (E), des paires de transistors individuelles ($T_i$, $t_i$) sont reliés à la sortie ($\bar{Q}$) de l'étage de comptage respectivement associé ($FF_i$) qui possède l'état UN immédiatement avant le départ du compteur dual (Z).

8. Circuit à semi-conducteurs suivant l'une des revendications 4 à 7, caractérisé par le fait que la paire de transistors ($T_i$, $t_i$) associée au $i^{ième}$ étage de comptage ($FF_i$) est reliée à la sortie (A) du circuit à semi-conducteurs, au moyen d'une chaîne de résistances constituée par ($n+1-i$) résistances individuelles identiques (R) branchées les unes à la suite des autres et par un transistor supplémentaire ($T^*$) associé simplement à la paire de transistors ($T_i$, $t_i$) concernée, et que, ce faisant, les dernières ($n-i$) de ces résistances (R) qui conduisent à la sortie (A) sont également respectivement associées à la paire de transistors ($T_{i+1}$, $t_{i+1}$) associée à l'étage de comptage suivant ($FF_{i+1}$).

9. Circuit à semi-conducteurs suivant la revendication 8, caractérisé par le fait que le potentiel d'alimentation (VM), qui sert à alimenter les seconds transistors ($t_i$) des paires de transistors ($T_i$, $t_i$), est relié, par l'intermédiaire d'une résistance de pontage (R'), à l'extrémité, qui est opposée à la sortie (A), de la chaîne de résistances qui est constituée par ($n+1$) ou ($n+2$) résistances individuelles identiques (R), et est appliqué à la sortie (A) du circuit à semi-conducteurs par l'intermédiaire de celle-ci.

10. Circuit à semi-conducteurs suivant la revendication 8 ou 9, caractérisé par le fait qu'aussi bien les résistances supplémentaires ($R^*$) qu'également la résistance de pontage (R') possèdent une valeur double de celle des résistances individuelles (R) constituant la chaîne de résistances.

11. Circuit à semi-conducteurs suivant l'une des revendications 6 à 10, caractérisé par le fait que l'entrée (TE) du compteur dual (Z), qui transmet les cadences de comptage, et la sortie de l'inverseur (I) alimentant le premier étage de comptage ($FF_1$), servent à la commande d'une autre paire de transistors ($T^*$, $t^*$), que les deux bornes, réunies entre elles, des transistors de cette paire de transistors sont reliées à la sortie (A) du circuit à semi-conducteurs, par l'intermédiaire de la chaîne de résistances, qui comporte ($n+2$) résistances individuelles (R) montées les unes derrière les autres, et d'une résistance supplémentaire ($R^*$) réservée exclusivement à cette paire supplémentaire de transistors ($T^*$, $t^*$), tandis que la seconde électrode sous tension du premier transistor ($T^*$) alimenté par l'inverseur (I) est reliée à l'entrée de signaux (E) du circuit, et la seconde électrode sous tension de l'autre transistor ($t^*$) est reliée directement au potentiel de service (VM).

12. Circuit à semi-conducteurs suivant l'une des revendications 1 à 10, caractérisé par le fait que l'entrée de comptage (TE) est commandée par un oscillateur, capable de délivrer des impulsions de comptage périodiques, en tant que générateur de cadence.

13. Circuit à semi-conducteurs suivant l'une des revendications 1 à 11, caractérisé par le fait que la fréquence des impulsions de comptage est choisie plus faible que la fréquence des impulsions des trains de signaux devant être appliqués à l'entrée de signaux (E) du circuit à semi-conducteurs.

14. Circuit à semi-conducteurs suivant l'une des revendications 1 à 12, caractérisé par le fait que le compteur numérique se présente sous la forme d'un compteur réversible, notamment suivant la demande brevet P 2 833 211.8.

15. Circuit à semi-conducteurs suivant l'une des revendications 1 à 13, caractérisé par le fait qu'il est assemblé suivant la technique des semi-conducteurs MIS monolithiques ou la technique bipolaire pour former un composant à semi-conducteurs.